# EUROPEAN PATENT APPLICATION

(11) **EP 3 612 008 A1**
(43) Date of publication of application: **19.02.2020**
(21) Application number: 17908173.2
(22) Date of filing: 31.08.2017
(51) Int. Cl.: H05K 1/11

(54) **PCB, PACKAGE STRUCTURE, TERMINAL, AND PCB PROCESSING METHOD**

(30) Priority: 03.05.2017 CN 201710304896
(71) Applicant: Huawei Technologies Co., Ltd., Longgang District Shenzhen, Guangdong 518129 (CN)
(72) Inventor: HONG, Weiqiang, Shenzhen Guangdong 518129 (CN); ZHOU, Dingguo, Shenzhen Guangdong 518129 (CN); ZHANG, Binquan, Shenzhen Guangdong 51812 (CN)
(74) Representative: Maiwald Patent- und Rechtsanwaltsgesellschaft mbH
(86) International application number: PCT/CN2017/100059
(87) International publication number: WO 2018/201648

(57) **Abstract**

This application relates to the component packaging field, and specifically, to a PCB, a package structure, a terminal, and a PCB processing method. The PCB includes a component soldering region disposed on the PCB, where the component soldering region includes a first region and a second region; first pads are disposed in the first region, and the first pads are configured to connect to a component through soldering; and the second region is a blank region, first grooves are disposed in the second region, and the second region is configured to connect to the component by using glue. In this application, the first grooves are added in the second region, so that a surface of the second region is of a three-dimensional structure. This increases a contact area between the second region and the glue, enhancing a bonding force between the PCB and the component, and avoiding relative displacement between the second region and the component. Therefore, in a case of drop or dramatic shake, a problem of glue cracking or a loose or even cracked solder joint is not to occur.

## Description

This application claims priority to Chinese Patent No. 201710304896.6, filed with the Chinese Patent Office on May 3, 2017, and entitled "METHOD FOR ENHANCING SOLDER JOINT STRENGTH, PCB SURFACE STRUCTURE, AND TERMINAL", which is incorporated herein by reference in its entirety.

### TECHNICAL FIELD

This application relates to the component packaging field, and specifically, to a PCB, a package structure, a terminal, and a PCB processing method.

### BACKGROUND

As terminals become increasingly lighter and thinner, with the improvement of integrated circuit processing, printed circuit boards (printed circuit board, PCB for short) in terminals are becoming increasingly thinner.

One or more layers of circuits are printed in a PCB. These circuits are used for transmission of electrical signals between various components electrically connected to the PCB. The various components disposed on the PCB are electrically connected to the PCB through soldering.

However, because printed circuit boards are increasingly thinner, when a terminal mechanically drops down, a solder joint with which a component is soldered to the terminal is likely to become loose or even cracked. As a result, the component cannot work, and finally the terminal cannot work.

### SUMMARY

Embodiments of this application provide a PCB, a package structure, a terminal, and a PCB processing method, to resolve a problem of likely occurrence of a loose or even cracked solder joint when a thin PCB drops down.

A first aspect of the embodiments of this application provides a PCB, where the PCB includes a component soldering region disposed on the PCB, where the component soldering region includes two regions: a first region and a second region; the first region is a soldering region, a region in which first pads are disposed, and the first pads are configured to connect to a component through soldering, so as to connect the component to a circuit in the PCB; the second region is a blank region, first grooves are disposed in this region, and the second region is connected to the component by using glue, where because the first grooves are located in the second region, the first grooves are also filled with the glue.

It can be learned that dispensing for PCBs plays a relatively important role to enhance solder point strength, while in design of some components, other than a solder joint region, that is, the first region in this application, regions, such as the second region in this application, actually do not have any pad. The second region and an opposite side of the component both have a planar structure, and filling glue between these planar structures is apt to a problem of an insufficient bonding force, for example, a risk of relative displacement between the second region and the component. As a result, in a case of drop, a problem of flue cracking or even solder joint failure is likely to occur. In this application, the first grooves are added in the second region, so that a surface of the second region is not of a planar structure, but of a three-dimensional structure. On one hand, a contact area between the second region and the glue is increased, enhancing a bonding force between the PCB and the component. On the other hand, after the glue is coagulated, design of the first grooves has a caging function similar to that of pinning, avoiding relative displacement between the second region and the component. Therefore, in a case of drop or dramatic shake, a problem of glue cracking or a loose or even cracked solder joint is not to occur. Moreover, the design of the first grooves can enhance anti-cutting strength of the glue and the PCB.

In some embodiments, the second region is coated with an ink layer, second pads are further disposed in the second region, the first groove is located between the second pad and the ink layer, and the second pad is insulated from the circuit in or the component on the PCB, meaning that the second pad is actually a blank pad. In addition, the ink layer is coated on conductors other than the pads. This can avoid a short circuit caused by soldering during usage and also protect the coated conductors, increasing a life span of the PCB. A reason why the second pads are disposed in the second region in this application is that processing of the second pad is similar to processing of the first pad, and therefore no extra technical processes are required, and the second pad only needs to be made when the first pad is made. This reduces processing complexity, and increases production efficiency of the package structure.

In some embodiments, the first groove is an annular groove, and the second pad is located inside an inner loop of the first groove. In other words, the first groove actually loops around the second pad. In technique, processing of such second pads and first grooves is relatively simple, similar to processing of adding pads. A difference lies in that the first groove needs to be added around the periphery of the second pad. The annular grooves can make a stronger bonding force between the PCB and the component after dispensing, so that the PCB and the component are more firmly bonded.

In some embodiments, second grooves are further disposed in the second region, where a width of the second groove and a width of the first groove are the same or different, and a depth of the second groove and a depth of the first groove are the same or different. In other words, the second groove is different from the first groove in design, with differences in both groove depth and groove width. Certainly, a difference may further lie in shape and arrangement. With these design schemes, the first groove and the second groove can cooperate with each other, enhancing the bonding force between the PCB and the component.

In some embodiments, the first groove communicates with the second groove. On one hand, this design is intended to make the first groove and the second groove an entirety, making it easier for the glue to fill in the grooves at dispensing. On the other hand, this design can further increase the contact area between the glue and the second region by using the first groove and the second groove that are different in structure, thereby enhancing the bonding force between the PCB and the component.

In some embodiments, the depth of the first groove and/or that of the second groove are/is not greater than a thickness of the ink layer. This design is intended to protect a laminate of the PCB. Because the depth of the groove is not greater than the thickness of the ink layer, no processing is required on the laminate of the PCB. Therefore, no extra technique is required for processing of the laminate, and processing is only required on the ink layer when the laminate of the PCB is being coated with the ink layer or after the laminate of the PCB is coated with the ink layer.

A second aspect of the embodiments of this application further provides a package structure, and the structure includes the PCB according to any one of the first aspect or the embodiments of the first aspect. The package structure is further provided with a chip, where pins of the chip are connected to a first region of the package structure, and the chip is connected to the second region of the package structure by using glue, and the first grooves are filled with the glue. Certainly, in embodiments of an aspect in which second grooves are provided, the second grooves are also filled with the glue. However, because the first grooves, or both the first grooves and the second grooves of the package structure are filled with the glue, a bonding force between the chip and the PCB is greatly strengthened, and the design of these grooves can enhance anti-cutting strength of the glue and the PCB.

A third aspect of the embodiments of this application further provides a terminal, and the terminal is provided with the package structure according to the second aspect, or the PCB according to any one of the first aspect or the embodiments of the first aspect.

A fourth aspect of the embodiments of this application further provides a PCB processing method, where the method includes:
processing first pads in a first region of a component soldering region of a PCB, where the first pads are connected to a circuit in the PCB, and the first pads are configured to connect to a component through soldering, where the component soldering region includes the first region and a second region, and the second region is a blank region;
coating an ink layer on the blank region; and
processing first grooves in the blank region.

It can be learned that the first grooves are added in the second region, so that a surface of the second region is not of a planar structure, but of a three-dimensional structure. On one hand, a contact area between the second region and the glue is increased, enhancing a bonding force between the PCB and the component. On the other hand, after the glue is coagulated, design of the first grooves has a caging function similar to that of pinning, avoiding relative displacement between the second region and the component. Therefore, in a case of drop or dramatic shake, a problem of glue cracking or a loose or even cracked solder joint is not to occur. Moreover, the design of the first grooves can enhance anti-cutting strength of the glue and the PCB.

In some embodiments, before the coating an ink layer on the blank region, the method further includes:
processing second pads in the blank region, where the second pad is located between the first groove and the ink layer, and the second pad is insulated from the circuit in or the component on the PCB. In other words, blank pads are added in the second region. A reason why the second pads are disposed in the second region is that processing of the second pad is similar to processing of the first pad, and therefore no extra technical processes are required, and the second pad only needs to be made when the first pad is made. This reduces processing complexity, and increases production efficiency of the package structure.

In some embodiments, the first groove is an annular groove, and the second pad is located inside an inner loop of the first groove. In other words, the first groove actually loops around the second pad. In technique, processing of such second pads and first grooves is relatively simple, similar to processing of adding pads. A difference lies in that the first groove needs to be added around the periphery of the second pad. The annular grooves can make a stronger bonding force between the PCB and the component after dispensing, so that the PCB and the component are more firmly bonded.

In some embodiments, the method further includes:
processing second grooves in the blank region, where a width of the second groove and a width of the first groove are the same or different, and a depth of the second groove and a depth of the first groove are the same or different. In other words, the second groove is different from the first groove in design, with differences in both groove depth and groove width. Certainly, a difference may further lie in shape and arrangement. With these design schemes, the first groove and the second groove can cooperate with each other, enhancing the bonding force between the PCB and the component.

In some embodiments, the first groove communicates with the second groove. On one hand, this design is intended to make the first groove and the second groove an entirety, making it easier for the glue to fill in the grooves at dispensing. On the other hand, this design can further increase the contact area between the glue and the second region by using the first groove and the second groove that are different in structure, thereby enhancing the bonding force between the PCB and the component.

In some embodiments, the depth of the first groove and/or that of the second groove are/is not greater than a thickness of the ink layer. This design is intended to protect a laminate of the PCB. Because the depth of the groove is not greater than the thickness of the ink layer, no processing is required on the laminate of the PCB. Therefore, no extra technique is required for processing of the laminate, and processing is only required on the ink layer when the laminate of the PCB is being coated with the ink layer or after the laminate of the PCB is coated with the ink layer.

### BRIEF DESCRIPTION OF DRAWINGS

FIG. 1 is a schematic diagram of a package structure of an eMMC chip corresponding to BGA packaging on a PCB;
FIG. 2A is a schematic diagram of connection between pads and component pins after mounting;
FIG. 2B is an A-A cross sectional view of FIG. 2A;
FIG. 3A is a diagram of an embodiment of a PCB in the embodiments of this application;
FIG. 3B is a schematic diagram of enlargement of a location A in FIG. 3A;
FIG. 4A is a diagram of an embodiment of a PCB in the embodiments of this application;
FIG. 4B is a schematic diagram of a B-B cross section in FIG. 4A;
FIG. 5A is a diagram of an embodiment of a PCB in the embodiments of this application;
FIG. 5B is a diagram of an embodiment of a PCB in the embodiments of this application;
FIG. 5C is a diagram of an embodiment of a PCB in the embodiments of this application; and
FIG. 6 is a diagram of an embodiment of a PCB processing method in the embodiments of this application.

### DESCRIPTION OF EMBODIMENTS

Embodiments of this application provide a PCB, a package structure, a terminal, and a PCB processing method, to resolve a problem of likely occurrence of a loose or even cracked solder joint when a thin PCB drops down.

To make a person skilled in the art better understand the technical solutions in this application, the following describes the embodiments of this application with reference to the accompanying drawings in the embodiments of this application.

In the specification, claims, and accompanying drawings of this application, the terms "first", "second", "third", "fourth", and so on (if any) are intended to distinguish between similar objects but do not necessarily indicate a specific order or sequence. It should be understood that the data termed in such a way are interchangeable when appropriate, so that the embodiments described herein can be implemented in other orders than the order illustrated or described herein. Moreover, the term "include", "contain", or any other variant thereof means to cover the non-exclusive inclusion. For example, a process, method, system, product, or device that includes a list of steps or units is not necessarily limited to those expressly listed steps or units, but may include other steps or units not expressly listed or inherent to such a process, method, system, product, or device.

PCBs in terminals are becoming increasingly thinner. For example, a thickness of a PCB in a terminal, such as a mobile phone or a palmtop computer, has evolved from 1.0 mm to 0.6 mm, or even to 0.5 mm. Current components on a PCB are mounted by mainly using a surface-mount technology (surface mounted technology, SMT for short). Therefore, a thickness decrease greatly increases a risk of a solder joint crack between a mounted component and the PCB, for example, a risk of a solder joint crack caused by a mechanical stress when a mobile phone drops down during usage.

SMT is a commonly-used technology in the electronic assembly industry. It is a circuit mounting technology in which a leadless or short-lead surface-mount component (SMC/SMD for short, a chip component in Chinese) is mounted onto a surface of the PCB or a surface of another substrate and is soldered and assembled through reflow soldering or dip soldering. Generally, SMT includes surface mounting, a surface-mount device, a surface-mount component, and SMT management. A basic SMT process includes: printing (red glue/solder paste), first inspection, mounting, second inspection, soldering, and third inspection. The first inspection may be, for example, automatic optic inspection (automatic optic inspection, AOI for short) or visual inspection, to inspect the printed red glue or solder paste. The second inspection is used to inspect connection between the mounted component and the PCB. A mounting principle is to mount a smaller component before a larger component. The soldering is performed by using, for example, hot air reflow soldering. The third inspection is mainly appearance inspection and function testing. Any defect found during the third inspection is fixed by using a soldering fixture, a hot air desoldering fixture, or the like. If no defects are found during the third inspection, depanelization is performed by hand or by using a depaneling machine.

There are many types of packaging for components that can be mounted using SMT, for example, ball grid array packaging (ball grid array, BGA for short), flip-chip (flip-chip) packaging, and other packaging manners. In BGA packaging, a grid array of solder balls are made on the bottom of a package substrate to serve as input/output (input/output, I/O for short) pins of a circuit to connect to the PCB, and are then sealed by using a molding resin or in a potting manner, so as to mount the component. Because the BGA is connected to the PCB by using solder bumps on the bottom of a chip, a quantity of I/O pins of the component is greatly increased, shortening a signal transmission path and providing good heat dissipation performance. Because the leads are short, self-inductance of a wire and mutual-inductance between wires are significantly low, and a frequency characteristic is good. When reflow soldering is performed, a wetting function between fused solder balls and solder paste facilitates good self-alignment, producing an effect of self-placement. This allows some deviation in mounting.

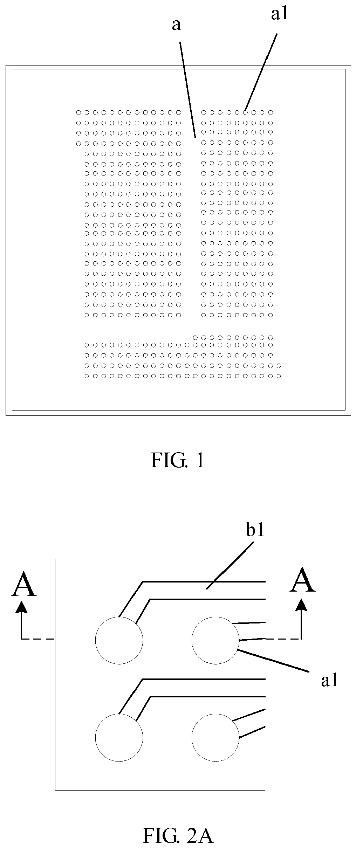

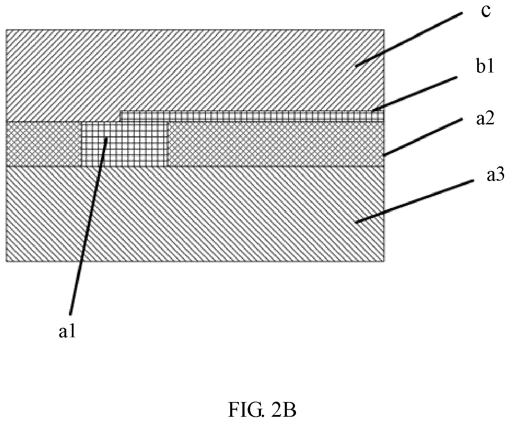

In BGA packaging, for some components, a quantity of I/O pins is relatively small, so that a pin region on the bottom of the component occupies only a portion of the entire bottom of the component. For example, an embedded multimedia card (embedded multimedia card, eMMC) has a relatively large outline, but a relatively small quantity of pins. When an eMMC is packaged on a PCB, there is a relatively large blank region on the bottom of the eMMC chip, and correspondingly, a component soldering region on the PCB corresponds to a size of the chip. As shown in FIG. 1, FIG 2A and FIG. 2B, FIG. 1 is a schematic structural diagram of packaging of an eMMC chip on a PCB by using BGA packaging. FIG. 2A is a schematic diagram of connection between pads and component pins after mounting, and FIG. 2B is an A-A cross sectional view of FIG. 2A. The PCB includes pads a1 corresponding to the solder ball grid array on the bottom of the eMMC chip, and each solder ball corresponds to one pin b1 of the eMMC chip. A region in which the pads are disposed is a main soldering region, and the rest region is a blank region. After the soldering region a is soldered to the solder ball grid array of the eMMC chip, glue is filled between the eMMC chip and the PCB for enhancement.

However, the blank region in which the eMMC chip is in contact with the PCB is excessively large. After dispensing, the glue in the blank region is in contact with the PCB in a planar manner, so that a bonding force between the glue and the PCB is insufficient. Therefore, in an event of collision, glue cracking is likely to occur. In addition, in comparison with a bottom area of the eMMC component, a quantity of solder joints and an area of the solder joint region are relatively small, so that a relatively large force is working on every solder joint, and therefore an external force produced by collision is likely to crack the solder joint.

As shown in FIG. 2A, pins b1 are connected to pads a1 by using solder balls. As shown in FIG. 2B, a PCB laminate a3 at the bottom, the pads a1 and an ink layer a2 that are above the laminate are included, and a glue layer c is above the ink layer. It can be seen from FIG. 2B that, if the glue layer c is separated from the ink layer a2 of the PCB, a risk of a solder joint crack between the pins b1 and the pads a1 may arise as a result. The ink layer a2 is an ink layer coated on a copper foil on the PCB. This ink layer may be coated on conductors other than the pads a1, to avoid a short circuit caused by soldering during usage and to increase a life span of the PCB. This ink layer is also referred to as a solder resist layer or a solder mask layer.

In can be learned that, for packages such as a BGA package, when a solder joint grid array is much smaller in area than an outline of the BGA package, the bonding force between the glue and the PCB is likely to be insufficient. Therefore, an ability to protect the solder joints is weak, an anti-collision and anti-dropping ability is poor, and it is likely that a solder joint becomes loose or even cracked in a case of collision or drop.

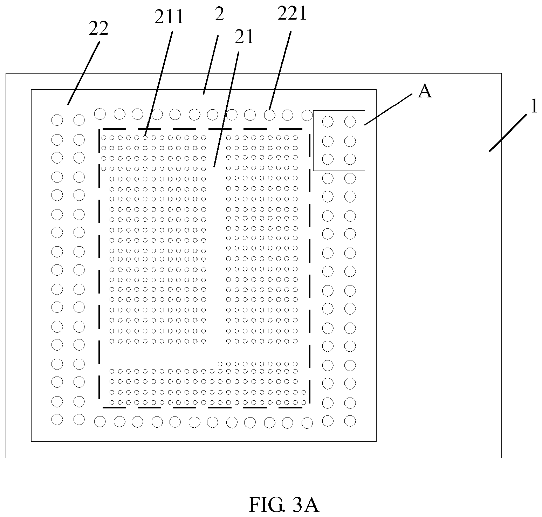

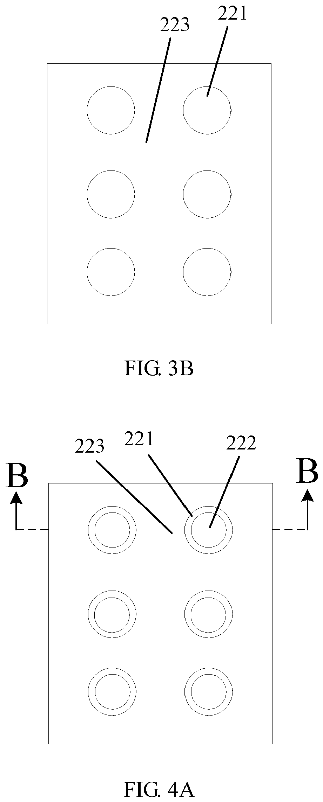

In view of this, the embodiments of this application provide a PCB to enhance a bonding force between glue and the PCB in BGA packaging by making first grooves 221 in a blank region outside a solder pad grid array on the PCB. Refer to FIG. 3A and FIG. 3B. FIG. 3A is a diagram of an embodiment of the PCB in the embodiments of this application, and FIG. 3B is a schematic diagram of enlargement of a location A in FIG. 3A. It can be seen from FIG. 3A that, a PCB 1 includes a component soldering region 2 disposed on the PCB 1, and the component soldering region 2 includes two regions: a first region 21 and a second region 22. The first region 21 is a region in which first pads 211 are disposed, specifically, a region within dashed lines in FIG. 3A. The first pads 211 are connected to a component through soldering, making the component connect to a circuit in the PCB 1. The second region 22 is a blank region, specifically, a region outside the dashed line region in the component soldering region in FIG. 3A, and first grooves 221 are disposed in this region. The second region 22 is connected to the component by using glue, and because the first grooves 221 are within the second region 22, the glue is also filled into the first grooves 221.

It should be noted that the first groove 221 may actually be a groove in various shapes. Only that the first groove 221 is a circular groove is used as an example in FIG. 3B, and actually the groove may alternatively be in other various shapes.

It can be learned that, in this application, the first grooves 221 are added in the second region 22, so that a surface of the second region is not of a planar structure, but of a three-dimensional structure. On one hand, a contact area between the second region 22 and the glue is increased, enhancing a bonding force between the PCB 1 and the component. On the other hand, after the glue is coagulated, design of the first grooves 221 has a caging function similar to that of pinning, avoiding relative displacement between the second region 22 and the component. Therefore, in a case of drop or dramatic shake, a problem of glue cracking or a loose or even cracked solder joint is not to occur. Moreover, the design of the first grooves 221 can enhance anti-cutting strength of the glue and the PCB 1.

For the first grooves 221, their locations on the PCB 1 and their structures may be set based on a shape and a size of the second region, and the following provides respective descriptions.

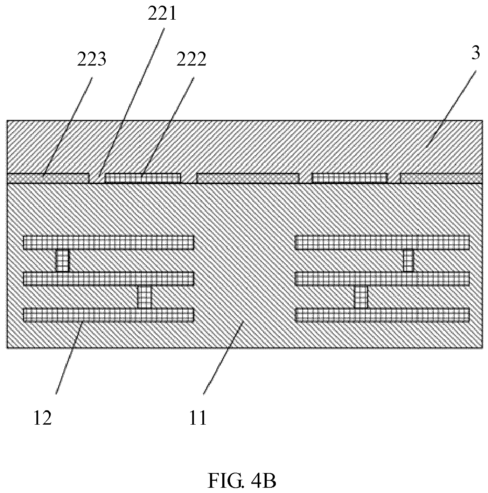

Optionally, referring to FIG. 4A, FIG. 4A is a diagram of an embodiment of the PCB in the embodiments of this application, and FIG. 4B is a schematic diagram of a B-B cross section of FIG. 4A. In FIG. 4A, the second region 22 is coated with an ink layer 223, second pads 222 are further disposed in the second region 22, and the first groove 221 is located between the second pad 222 and the ink layer 223. In FIG. 4B, the bottom is a laminate 11 of the PCB 1, and a circuit 12 is already disposed inside the laminate 11. The second pads 222 and the ink layer 223 are both disposed on a surface of the laminate 11. The first groove 221 is located between the second pad 222 and the ink layer 223, above the second pads 222 and the ink layer 223 is a glue layer 3, and certainly, the glue layer 3 also fills in the first grooves 221. It can be seen from FIG. 4B that, the second pad 222 is insulated from the circuit 12 in or the component on the PCB 1. In other words, the second pad 222 and the circuit 12 in the component on the PCB 1 are not connected to each other. Therefore, the second pad 222 is actually a blank pad that has no contact with any metal transmitting an electrical signal on the PCB 1 or on the component. In this case, the first groove 221 may be an annular groove, and the second pad 222 may be located inside an inner loop of the first groove 221. In other words, the first groove 221 actually loops around the second pad 222. In technique, processing of such second pads 222 and first grooves 221 is relatively simple, requiring only that the first groove 221 be added around the periphery of the second pad 222. The annular first grooves 221 can make a stronger bonding force between the PCB 1 and the component after dispensing, so that the PCB 1 and the component are more firmly bonded. It can be seen from FIG. 4A that an outer diameter of the second pad 222 is in contact with an inner diameter of the first groove 221. This design is intended to process the first groove 221 while the second pad is processed. In addition, the ink layer 223 is coated on conductors other than the first pads 211 and the second pads 222. This can avoid a short circuit caused by soldering during usage and also protect the coated conductors, increasing a life span of the PCB 1.

It should be noted that in SMT processing, there are two kinds of pads. One is a non solder mask defined (non solder mask defined, NSMD for short) pad, and the other is a solder mask defined (solder mask defined, SMD for short) pad. A difference between the two lies in that the SMD pad is a pad formed by coating a copper foil with a green oil layer, and the NSMD pad is a separate pad with a groove between the pad and an ink layer.

In this embodiment of this application, the second pad may be an NSMD pad. The NSMD pad does not need to be soldered to pins of the component, and therefore no tin needs to be applied at the NSMD pad in a soldering process of SMT. Certainly, even if the NSMD pad is printed with tin in the soldering process of SMT and subsequent dispensing is limited to only between the NSMD pad and the glue, a function of the first groove 221 between the NSMD pad and the ink layer 223 in this embodiment of this application is not affected. A process of disposing the second pad 222 in the second region 22 is similar to processing of the first pad, and therefore no extra technical processes are required, and the second pad only needs to be made when the first pad 211 is made. This reduces processing complexity, and increases production efficiency of the package structure.

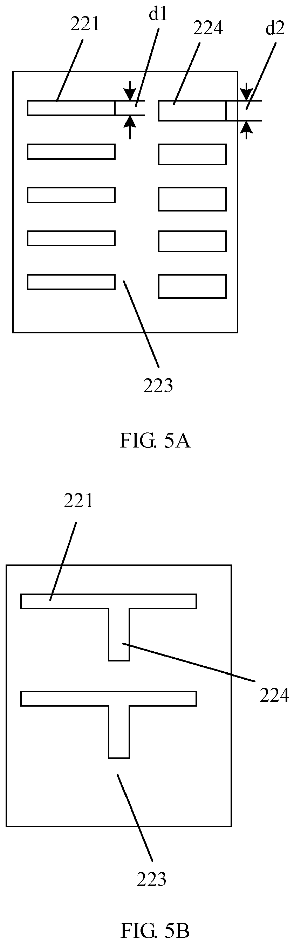

Optionally, as shown in FIG. 5A, second grooves 224 are further disposed in the second region 22, where a width of the second groove 224 and a width of the first groove 221 are the same or different, and a depth of the second groove 224 and a depth of the first groove 221 are the same or different. In other words, the second groove 224 is different from the first groove 221 in design, with differences in both groove depth and groove width. Certainly, a difference may further lie in shape and arrangement. With these design schemes, the first groove 221 and the second groove 224 can cooperate with each other, enhancing the bonding force between the PCB 1 and the component.

For example, refer to FIG. 5A. FIG. 5A is a diagram of an embodiment of a PCB in the embodiments of this application. A width of the first groove is d1, and a width of the second groove is d2. It can be learned that the width of the second groove 224 is greater than that of the first groove 221, and that the depth of the second groove 224 is greater than that of the first groove 221. Certainly, the second groove 224 may be greater than the first groove 221 in width or depth. In addition to the regular structures shown in FIG. 5A, the first groove 221 and the second groove 224 may alternatively have other structures. For example, a top width and a bottom width of the groove are different.

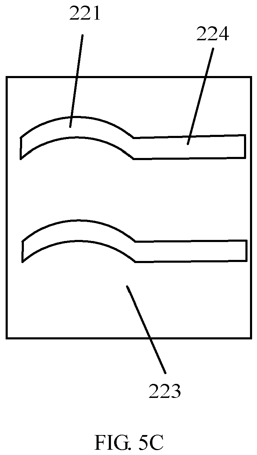

In addition, the first groove 221 may be separated from the second groove 224, or the first groove 221 may communicate with the second groove 224. Specifically, refer to FIG. 5B and FIG. 5C. FIG. 5B is a diagram of an embodiment of the PCB in the embodiments of this application and FIG. 5C is a diagram of an embodiment of the PCB in the embodiments of this application. As shown in FIG. 5B, an end of the first groove 221 is connected to the second groove 224, and certainly, as shown in FIG. 5C, an end of the first groove 221 may alternatively be connected to an end of the second groove 224. It can be understood that there are a plurality of connection manners in addition to the two connection manners provided that the glue can easily fill. On one hand, this design is intended to make the first groove 221 and the second groove 224 an entirety, making it easier for the glue to fill in the grooves at dispensing. On the other hand, this design can further increase the contact area between the glue and the second region by using the first groove 221 and the second groove 224 that are different in structure, thereby enhancing the bonding force between the PCB 1 and the component.

Optionally, the depth of the first groove 221 and/or that of the second groove 224 are/is not greater than a thickness of the ink layer 223. Referring to FIG. 4B, the depth of the first groove 221 is not greater than the thickness of the ink layer 223. This design is intended to protect a laminate of the PCB 1. Because the depth of the first groove 221 and/or that of the second groove 224 are/is not greater than the thickness of the ink layer 223, no processing is required on the laminate of the PCB 1. Therefore, no extra technique is required for processing of the laminate, and processing is only required on the ink layer 223 when the laminate of the PCB 1 is being coated with the ink layer 223 or after the laminate of the PCB 1 is coated with the ink layer 223.

The foregoing describes the PCB in the embodiments of this application, and the following describes a package structure in this application. The package structure may include the PCB in any one of the embodiments shown in FIG. 3A to FIG. 5B. The PCB 1 is further provided with a chip, and pins of the chip are connected to the first region 21 of the package structure. The chip is connected to the second region 22 of the package structure by using glue, and the first grooves 221 are filled with the glue. However, because the first grooves 221 or both the first grooves 221 and the second grooves 224 of the package structure are filled with the glue, a bonding force between the chip and the PCB 1 is greatly strengthened, and the design of these grooves can enhance anti-cutting strength of the glue and the PCB 1.

The foregoing describes the package structure in the embodiments of this application, and the following describes a terminal using the package structure in this application. The package structure of the terminal is the package structure in the foregoing solution, or the PCB in any one of the embodiments shown in FIG. 3A to FIG. 5B.

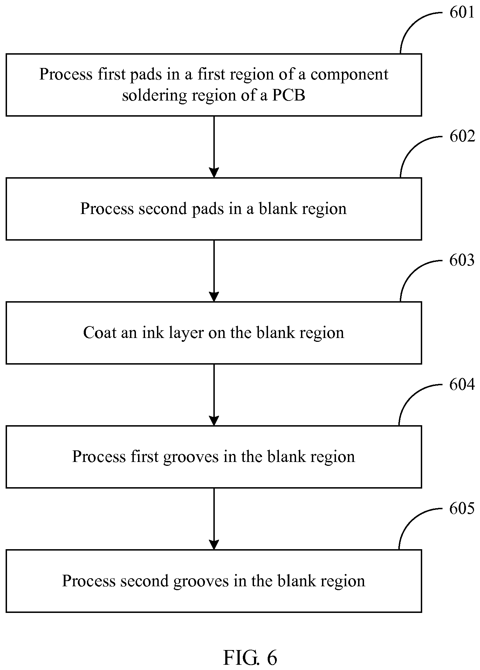

The foregoing describes the terminal in the embodiments of this application, and the following describes a package structure processing method in the embodiments of this application. Refer to FIG. 6. FIG. 6 is a diagram of an embodiment of the package structure processing method in the embodiments of this application. As shown in FIG. 6, the method may include the following steps.

601: Process first pads in a first region of a component soldering region of a PCB.

The first pads are connected to a circuit in the PCB, and the first pads are configured to connect to a component through soldering. The component soldering region includes a first region and a second region, and the second region is a blank region.

The first pad is a structure for soldering to a chip pin during packaging of the PCB and a chip. The first pad is a structure disposed on a surface of the PCB and connecting to a circuit in the PCB after the circuit in the PCB is printed.

603: Coat an ink layer on the blank region. The ink layer may be an ink layer coated on a copper foil on the PCB. This ink layer may be coated on the surface of the PCB except the pads, to avoid a short circuit caused by soldering during usage, and to increase a life span of the PCB. This ink layer is also referred to as a solder resist layer or a solder mask layer.

604: Process first grooves in the blank region.

The first grooves are located in the blank region, and the first groove may be in any shape provided that the blank region has a three-dimensional structure.

It can be learned that the first grooves are located in the second region, so that a surface of the second region is not of a planar structure, but of a three-dimensional structure. On one hand, a contact area between the second region and the glue is increased, enhancing a bonding force between the PCB and the component. On the other hand, after the glue is coagulated, design of the first grooves has a caging function similar to that of pinning, avoiding relative displacement between the second region and the component. Therefore, in a case of drop or dramatic shake, a problem of glue cracking or a loose or even cracked solder joint is not to occur. Moreover, the design of the first grooves can enhance anti-cutting strength of the glue and the PCB.

Optionally, before step 603, the method may further include the following step.

602: Process second pads in a blank region.

The second pad may be located in the first groove, and the second pad is insulated from a circuit or the component on the PCB. In other words, blank pads are added in the second region. A reason why the second pads are disposed in the second region is that processing of the second pad is similar to processing of the first pad, and therefore no extra technical processes are required, and the second pad only needs to be made when the first pad is made. This reduces processing complexity, and increases production efficiency of the package structure.

It should be noted that if the second pad is an NSMD pad, the first groove may be a groove around the NSMD pad. The processing of the first groove in step 604 may be completed before the coating of ink in step 603. In addition, processing of the first pad is essentially the same as processing of the second pad, and therefore on the circuit-printed PCB, the first pad may be processed before the second pad, or the second pad is processed before the first pad, or the first pad and the second pad are processed simultaneously. Therefore, there is no absolute order relationship between step 602 and step 601.

Optionally, the first groove is located between the second pad and the ink layer in the second region, the first groove is an annular groove, and the second pad is located inside an inner loop of the first groove.

It should be noted that, for addition of the second pad and a location relationship between the first groove and the second pad, reference may be made to the description of the embodiment shown in FIG. 4. Details are not described herein again.

Optionally, the method further includes the following step.

605: Process second grooves in the blank region.

A width of the second groove and a width of the first groove are the same or different, and a depth of the second groove and a depth of the first groove are the same or different. In other words, the second groove is different from the first groove in design, with differences in both groove depth and groove width. Certainly, a difference may further lie in shape and arrangement. With these design schemes, the first groove and the second groove can cooperate with each other, enhancing the bonding force between the PCB and the component.

It should be noted that, for the width, depth, shape and arrangement of the second groove and those of the first groove, reference may be made to the description of the embodiment shown in FIG. 5A. Details are not described herein again.

Optionally, the first groove communicates with the second groove. On one hand, this design is intended to make the first groove and the second groove an entirety, making it easier for the glue to fill in the grooves at dispensing. On the other hand, this design can further increase the contact area between the glue and the second region by using the first groove and the second groove that are different in structure, thereby enhancing the bonding force between the PCB and the component.

It should be noted that, for a connection manner of the second groove and the first groove, reference may be made to the description of the embodiment shown in FIG. 5B. Details are not described herein again.

Optionally, the depth of the first groove and/or that of the second groove are/is not greater than a thickness of the ink layer. This design is intended to protect a laminate of the PCB. Because the depth of the groove is not greater than the thickness of the ink layer, no processing is required on the laminate of the PCB. Therefore, no extra technique is required for processing of the laminate, and processing is only required on the ink layer when the laminate of the PCB is being coated with the ink layer or after the laminate of the PCB is coated with the ink layer.

All or some of the foregoing embodiments may be implemented by using software, hardware, firmware, or any combination thereof. When software is used to implement the embodiments, the embodiments may be implemented entirely or partially in a form of a computer program product.

The computer program product includes one or more computer instructions. When the computer program instructions are loaded and executed on a computer, the procedures or functions according to the embodiments of the present invention are all or partially generated. The computer may be a general-purpose computer, a dedicated computer, a computer network, or another programmable apparatus. The computer instruction may be stored in a computer readable storage medium or may be transmitted from a computer readable storage medium to another computer readable storage medium. For example, the computer instructions may be transmitted from a website, computer, server, or data center to another website, computer, server, or data center in a wired (for example, through a coaxial cable, an optical fiber, or a digital subscriber line (DSL)) or wireless (for example, through infrared, radio, or microwave) manner. The computer readable storage medium may be any usable medium accessible by a computer, or a data storage device, such as a server or a data center, integrating one or more usable media. The usable medium may be a magnetic medium (for example, a floppy disk, a hard disk, or a magnetic tape), an optical medium (for example, a DVD), a semiconductor medium (for example, a solid state disk Solid State Disk, (SSD)), or the like.

It may be clearly understood by a person skilled in the art that, for the purpose of convenient and brief description, for a detailed working process of the foregoing system, apparatus, and unit, reference may be made to a corresponding process in the foregoing method embodiments, and details are not repeated herein.

In the several embodiments provided in this application, it should be understood that the disclosed system, apparatus, and method may be implemented in other manners. For example, the described apparatus embodiment is merely an example. For example, the unit division is merely logical function division and may be other division in actual implementation. For example, a plurality of units or components may be combined or integrated into another system, or some features may be ignored or not performed. In addition, the displayed or discussed mutual couplings or direct couplings or communication connections may be indirect couplings or communication connections through some interfaces, apparatuses or units, and may be implemented in electrical, mechanical, or other forms.

The units described as separate parts may or may not be physically separate. Parts displayed as units may or may not be physical units, and may be located in one position or distributed on a plurality of network units. Some or all of the units may be selected depending on actual needs to achieve the objectives of the solutions of the embodiments.

In addition, functional units in the embodiments of this application may be integrated into one processing unit, or each of the units may exist alone physically, or two or more units are integrated into one unit. The integrated unit may be implemented in a form of hardware, or may be implemented in a form of a software functional unit.

## Claims

1. A printed circuit board PCB, comprising a component soldering region disposed on the PCB, wherein the component soldering region comprises a first region and a second region; first pads are disposed in the first region, and the first pads are configured to connect to a component through soldering; and the second region is a blank region, first grooves are disposed in the second region, and the second region is configured to connect to the component by using glue.

2. The PCB according to claim 1, wherein the second region is coated with an ink layer, second pads are further disposed in the second region, the first groove is located between the second pad and the ink layer, and the second pad is insulated from a circuit in or the component on the PCB.

3. The PCB according to claim 1 or 2, wherein second grooves are further disposed in the second region, wherein a width of the second groove and a width of the first groove are the same or different, and a depth of the second groove and a depth of the first groove are the same or different.

4. The PCB according to claim 3, wherein the first groove communicates with the second groove.

5. The PCB according to claim 3 or 4, wherein the depth of the first groove and/or that of the second groove are/is not greater than a thickness of the ink layer.

6. A package structure, comprising a chip and the printed circuit board PCB according to any one of claims 1 to 5, wherein
pins of the chip are connected to a first region of the PCB through soldering, the chip is connected to a second region of the PCB by using glue, and the first grooves are filled with the glue.

7. A terminal, wherein the terminal comprises the package structure according to claim 6, or the printed circuit board PCB according to any one of claims 1 to 5.

8. A printed circuit board PCB processing method, comprising:
processing first pads in a first region of a component soldering region of a PCB, wherein the first pads are connected to a circuit in the PCB, and the first pads are configured to connect to a component through soldering, wherein the component soldering region comprises the first region and a second region, and the second region is a blank region;
coating an ink layer on the blank region; and
processing first grooves in the blank region.

9. The PCB processing method according to claim 8, wherein before the coating an ink layer on the blank region, the method further comprises:
processing second pads in the blank region, wherein the second pad is located between the first groove and the ink layer, and the second pad is insulated from the circuit in or the component on the PCB.

10. The PCB processing method according to claim 8 or 9, wherein the method further comprises:
processing second grooves in the blank region, wherein a width of the second groove and a width of the first groove are the same or different, and a depth of the second groove and a depth of the first groove are the same or different.
